# EUROPÄISCHE PATENTANMELDUNG

(11) **EP 2 073 268 A2**
(43) Veröffentlichungstag der Anmeldung: **24.06.2009**
(21) Anmeldenummer: 08019791.6
(22) Anmeldetag: 13.11.2008
(51) Int. Cl.: H01L 27/142

(54) **Verfahren und Vorrichtung zur Herstellung eines semitransparenten photovoltaischen Moduls**

(30) Priorität: 22.12.2007 DE 102007062620
(71) Anmelder: SCHOTT Solar GmbH, 63755 Alzenau (DE)
(72) Erfinder: Lechner, Peter, 85591 Vaterstetten (DE); Psyk, Walter, 81371 München (DE)
(74) Vertreter: Berngruber, Otto

(57) **Zusammenfassung**

Zur Herstellung eines semitransparenten photovoltaischen Moduls (1) werden nach dem Beschichten des transparenten Substrats (2) mit einer transparenten Frontelektrodenschicht (3), einer Halbleiterschicht (4) und einer metallischen Rückelektrodenschicht (5) Teilbereiche (9) der Halbleiterschicht (4) und der Rückelektrodenschicht (5) entfernt. Dazu wird auf die Frontelektrodenschicht (3) an den Bereichen (9), an denen die Halbleiterschicht (4) und die Rückelektrodenschicht (5) entfernt werden sollen, mit einem Tintenstrahldrucker (15) eine Ablösemasse (14) aufgetragen. Danach erfolgt das Abscheiden der Halbleiterschicht (4) und der Rückelektrodenschicht (5) auf der Ablösemasse (4). Anschließend wird die Halbleiterschicht (4) und die Rückelektrodenschicht (5) zusammen mit der Ablösemasse (14) von der Frontelektrodenschicht (3) entfernt, um die durchsichtigen Teilbereiche (9) zu bilden.

## Beschreibung

Die Erfindung bezieht sich auf ein Verfahren zur Herstellung eines semitransparenten photovoltaischen Moduls nach dem Oberbegriff des Anspruchs 1 und eine Vorrichtung zur Durchführung des Verfahrens.

Photovoltaische Module weisen auf der transparenten Frontelektrodenschicht, beispielsweise aus einem transparenten elektrisch leitfähigem Metalloxid (TCO), die auf einem transparentem Substrat, wie Glas, abgeschieden ist, eine undurchsichtige Halbleiterschicht und eine undurchsichtige metallische Rückelektrodenschicht auf. Um das Modul semitransparent und damit durchsichtig auszubilden, werden die undurchsichtige Halbleiter- und Rückelektrodenschicht in über das Modul verteilten Teilbereichen entfernt.

Das photovoltaische Modul besteht dabei im allgemeinen aus Zellen, die durch Kontakt der Rückelektrodenschicht einer Zelle mit der Frontelektrodenschicht der benachbarten Zelle serienverschaltet sind. Zur Serienverschaltung wird dabei u. a. eine senkrecht zur Stromflussrichtung verlaufende Trennlinie gebildet, an der die Halbleiterschicht und die Rückelektrodenschicht entfernt ist, sodass ein weiterer durchsichtiger Teilbereich gebildet wird.

Zum Entfernen der Halbleiterschicht und der Rückelektrodenschicht ist die Laser-Ablation bekannt. Dabei wird der Laserstrahl durch das Substratglas auf die Schicht fokussiert und die Halbleiter- und Rückelektrodenschicht entfernt. Der Nachteil dieser Methode besteht darin, dass der Laserstrahl relativ schmale Bereiche der Halbleiter- und Rückelektrodenschicht mit einer Breite von lediglich etwa 50 µm entfernt. Um damit einen Transmissionsgrad der Semitransparenz von 10 % zu erzeugen, müssen pro Quadratmeter Modulfläche die Halbleiter- und Rückelektrodenschicht über eine Länge von insgesamt zwei Kilometer entfernt werden. Bei einer typischen Verfahrgeschwindigkeit des Laserstrahls relativ zur Substratoberfläche von 1 m/s beträgt die Bearbeitungszeit somit mindestens 2000 s, ist also extrem lang.

Eine andere Methode sieht das Herstellen der durchsichtigen Teilbereiche mittels nass- oder trockenchemischer Ätzverfahren vor. Der Nachteil dieser Methode besteht in der Notwendigkeit, die Bereiche, die nicht entfernt werden sollen, vor dem Ätzangriff wirkungsvoll zu schützen. In der Realität ist diese Forderung nicht im vollem Umfang zu erfüllen und birgt das Risiko einer unmittelbaren Schädigung des photovoltaischen Moduls, beispielsweise durch Kurzschlüsse oder auch langfristige Zuverlässigkeitsprobleme beim Betrieb des Moduls.

Aus EP 500 451 B1 ist es bereits bekannt, auf die Rückelektrodenschicht an den Bereichen, an denen die durchsichtigen Teilbereiche gebildet werden sollen, eine haftende Paste aufzubringen, mit der die Rückelektrodenschicht in diesen Bereichen durch Abziehen entfernt wird, worauf die Entfernung der Halbleiterschicht in diesen Bereichen nasschemisch mit Natronlauge durchgeführt wird.

Aufgabe der Erfindung ist es, die Bearbeitungszeit zur Herstellung von semitransparenten photovoltaischen Modulen hoher Qualität wesentlich zu verkürzen.

Dies wird erfindungsgemäß durch das im Anspruch 1 gekennzeichnete Verfahren erreicht. In den Ansprüchen 2 bis 10 sind bevorzugte Ausgestaltungen des erfindungsgemäßen Verfahrens wiedergegeben. Im Anspruch 11 ist eine bevorzugte Vorrichtung zur Durchführung des erfindungsgemäßen Verfahrens gekennzeichnet. In den Ansprüchen 12 bis 15 sind bevorzugte Ausgestaltungen der Vorrichtung angegeben.

Nach dem erfindungsgemäßen Verfahren wird das transparente Substrat, beispielsweise eine Glasscheibe oder Kunststofffolie, zunächst mit der transparenten Frontelektrodenschicht beschichtet. Die Beschichtung mit der transparenten Frontelektrodenschicht kann beispielsweise durch Glimmentladungsabscheidung (PECVD) erfolgen. Die Frontelektrodenschicht besteht vorzugsweise aus TCO (Transparent Conductive Oxide), wie Zinnoxid, Zinkoxid und dergleichen.

Anschließend wird auf die Bereiche der Frontelektrodenschicht, an denen die durchsichtigen Teilbereiche des Moduls nach dem Entfernen der Halbleiterschicht und der undurchsichtigen Rückelektrodenschicht entstehen sollen, mit einem Tintenstrahldrucker eine Ablösemasse aufgetragen.

Die "Tinte" des Tintenstrahldruckers besteht beispielsweise aus einer Dispersion oder Lösung der Ablösemasse. Dabei wird vorzugsweise ein leicht flüchtiges Lösungsmittel als Löse- oder Dispersionsmittel verwendet, beispielsweise Alkohol. Bei einer Dispersion können die dispergierten Teilchen beispielsweise aus abrasiven Teilchen (z.B. Farbstoff) bestehen. Die Tinte soll für das spätere Ablösen, z.B. durch das Eintauschen des Moduls in Wasser, selber wasserlöslich sein.

Nach dem Trocknen der Ablösemasse wird auf der mit der trockenen Ablösemasse versehenen Frontelektrodenschicht die Halbleiterschicht abgeschieden.

Die Halbleiterschicht kann beispielsweise aus amorphem, nanokristallinem oder mikrokristallinem Silizium bestehen. Die Abscheidung der Halbleiterschicht erfolgt normalerweise bei einer Temperatur über 200°C, beispielsweise durch PECVD oder mit dem sogenannten "Hot-Wire"-Verfahren.

Nach dem Abscheiden der Halbleiterschicht im Vakuum wird das Substrat mit der darauf abgeschiedenen Halbleiterschicht z. B. auf Atmosphärendruck belüftet und z. B. auf Raumtemperatur abgekühlt. Anschließend erfolgt die Abscheidung der metallischen Rückelektrodenschicht, beispielsweise durch Sputtern.

Danach werden die Halbleiterschicht, die Rückelektrodenschicht und die Ablösemasse im Bereich der Ablösemasse entfernt, um die durchsichtigen Teilbereiche zu bilden.

Dazu kann das Modul z. B. einem Lösungsmittel, beispielsweise Wasser, ausgesetzt werden, z. B. durch Eintauchen. Überraschenderweise hat sich gezeigt, dass sich dadurch die Ablösemasse von der Frontelektrodenschicht löst und damit die Halbleiterschicht und die Rückelektrodenschicht von dem Bereich auf der Ablösemasse entfernt werden, zusammen mit der Ablösemasse.

Das Eindringen des Lösemittels in die Ablösemasse durch die darauf abgeschiedene metallische Rückelektrodenschicht und Halbleiterschicht hindurch ist möglicherweise auf Mikrorisse und dergleichen Öffnungen in der Rückelektrodenschicht und der Halbleiterschicht zurückzuführen. Der genaue Vorgang für das überraschende Eindringen des Lösungsmittels in die durch die Halbleiter- und die Rückelektrode eingekapselte Ablösemasse ist allerdings nicht bekannt.

Wie vorstehend erwähnt, kann als "Tinte" beispielsweise eine Dispersion der Ablösemasse aus Alkoholen, Harzen und organischen Farbstoffen in z. B. Alkohol mit dem Tintenstrahldrucker aufgetragen werden. Jedoch kann auch jede andere Ablösemasse verwendet werden, sofern sie in der Lage ist, beim Aufbringen mit einem Tintenstrahldrucker einen dünnen Film zu bilden. Ferner muss die Ablösemasse beispielsweise bei einer Temperatur über 200°C temperaturbeständig und vakuumbeständig sein, damit die Halbleiterschicht beispielsweise durch PECVD aufgetragen werden kann. Ferner muss die Ablösemasse dann der anschließenden Belüftung, z. B. auf Atmosphärendruck und Abkühlung z. B. auf Raumtemperatur unter guter Haftung an der Frontelektrodenschicht widerstehen und zwar ohne die Bildung von Rissen, da sonst bei der anschließenden Beschichtung mit der Halbleiter- bzw. Rückelektrodenschicht das Halbleitermaterial bzw. das Metall der Rückelektrodenschicht durch die Risse in der Ablösemasse hindurch gegebenenfalls bis zur Frontelektrodenschicht vordringen kann, sodass nicht entfernbare Rückstände des Halbleitermaterials und des Metalls der Rückelektrodenschicht an der Frontelektrodenschicht haften, wodurch, abgesehen von der optischen Beeinträchtigung, Kurzschlüsse hervorgerufen werden können.

Die durchsichtigen Teilbereiche des Moduls können linienförmig ausgebildet, insbesondere gerade linienförmige Bereiche sein. Sie können sich in Fließrichtung des elektrischen Stroms des Moduls und/oder senkrecht zur Stromfließrichtung oder in einer anderen Richtung des Moduls erstrecken.

Die durchsichtigen Bereiche können ferner dann vorgesehen sein, wenn das Modul aus mehreren Zellen gebildet wird, die miteinander serienverschaltet sind, wodurch ein Modul mit höherer Spannung erhalten wird. Die Serienverschaltung erfolgt durch Kontakt der Rückelektrodenschicht einer Zelle mit der Frontelektrodenschicht der benachbarten Zelle. Dabei ist zur Serienverschaltung zweier benachbarter Zellen unter anderem eine senkrecht zur Stromflussrichtung verlaufende Trennlinie vorgesehen, die die Aufgabe der elektrischen Trennung der Rückelektrode benachbarter Zellen übernimmt. Diese Trennlinie bildet vorzugsweise ebenfalls durchsichtige Teilbereiche, indem mit dem Tintenstrahldrucker durch das Auftragen der Ablösemasse auf die Frontelektrode und die darüber aufgebrachte Halbleiter- und Rückelektrodenschicht entfernt wird.

Weiter muss bei einem diskreten Minuspol des Moduls, der ebenfalls die durchsichtigen Teilbereiche parallel zum Stromfluss, wie auch eine durchsichtige Trennlinie der Serienverschaltung aufweist, eine weitere Trennlinie in der Halbleiterschicht, gespiegelt zur Trennlinie der Rückelektrodenschicht der Serienverschaltung, gebildet werden. Ohne diese zusätzliche Trennlinie in der Halbleiterschicht hätte das Modul keinen Minuspol. Eine elektrische Kontaktierung durch die z.B. parallel zur Stromrichtung verlaufenden Trennlinien, die das elektrische Minus-Potential der zu diesem Minuspol angrenzenden Zelle hat, ist eine alternative Möglichkeit, dass negative Potential des Moduls abgreifen zu können. In diesem Fall ist die technisch zuverlässig Kontaktierung zu beachten

Wenn eine Serienverschaltung vorgesehen ist, wird im allgemeinen zwischen zwei benachbarten Zellen zusätzlich eine weitere Trennlinie in der Frontelektrodenschicht erzeugt, ferner eine weitere dazu versetzte parallele Trennlinie in der Halbleiterschicht. Diese beiden Trennlinien werden jedoch beim Abscheiden der Halbleiterschicht bzw. der Rückelektrodenschicht mit der Halbleiterschicht bzw. der Rückelektrodenschicht verfüllt. Die beiden weiteren Trennlinien, die parallel zu der Trennlinie verlaufen, die durch die Halbleiterschicht und die Rückkontaktschicht geht und zu einem durchsichtigen Teilbereich führt, können beispielsweise durch Laser-Ablation gebildet werden.

Die durchsichtigen Teilbereiche des erfindungsgemäßen transparenten Moduls können also durch Teilbereiche innerhalb des Moduls oder bei einem aus mehreren Zellen gebildeten Modul innerhalb der Zellen gebildet sein, und/oder durch die Trennlinie(n) durch die Halbleiterschicht und die Rückelektrodenschicht zur Serienverschaltung. Vorzugsweise weist das Modul sowohl Zellen mit transparenten Teilbereichen wie transparente Trennlinien der Serienverschaltung auf. Wenn die transparenten Teilbereiche innerhalb der Zellen durch in Fließrichtung verlaufende gerade linienförmige Teilbereiche gebildet werden, wird zusammen mit den dazu verlaufenden transparenten Trennlinien für die Serienverschaltung ein optischer ansprechendes Gittermuster erzeugt. Die linienförmigen transparenten Teilbereiche innerhalb der Zellen und die transparenten Trennlinien zur Serienverschaltung können dabei die gleiche Breite aufweisen oder unterschiedlich breit ausgebildet sein, beispielsweise können die transparenten Trennlinien schmäler als die transparenten Linien innerhalb der Zellen bzw. des Moduls sein.

Die Dicke der Ablösemasse soll nach dem Trocknen in der Größenordnung der Schichtdicke der Halbleiterschicht sein, die vorzugsweise 0,1 bis 5 µm, insbesondere 0,3 bis 2 µm beträgt.

Als Tintenstrahldrucker kann beispielsweise ein kontinuierlicher oder sogenannten Continious Ink Jet oder CIJ-Drucker oder ein Drop-On-Demand oder DOD-Drucker verwendet werden.

Beim Bedrucken werden der Tintenstrahldrucker und das mit der Frontelektrodenschicht versehene Substrat relativ zueinander bewegt. Dazu kann das mit der Frontelektrodenschicht versehene Substrat beispielsweise auf einem Schlitten angeordnet sein, der in einer oder zwei zueinander senkrechten Richtungen bewegbar ist u(z.B. ein X/Y-Koordinatentisch und/oder der Tintenstrahldrucker kann an einem Träger, der in einer zu der einen Bewegungsrichtung des Schlittens senkrechten Richtung bewegbar ist (Gantry-System), vorgesehen sein. Auch kann das mit der Frontelektrodenschicht versehene Substrat auf einem Tisch angeordnet sein, wobei der Träger gegenüber dem Tisch in zwei zueinander senkrechte Richtungen oder nur in eine Richtung bewegbar sein kann (Split-Axis-System), wobei der Tintenstrahldrucker dann entlang dem Träger bewegbar sein kann.

Mit dem Tintenstrahldrucker wird ein Muster der Ablösemasse auf der Frontelektrodenschicht aufgetragen, das den transparenten Teilbereichen des Moduls oder innerhalb der Zellen und/oder den transparenten Trennlinien der Serienverschaltung der Zellen entspricht.

Die Teilchendispersion oder Lösung, die als "Tinte" zur Bildung der Ablösemasse auf der Frontelektrodenschicht aufgebracht wird, muss die Frontelektrodenschicht gut benetzen, damit ein rückstandsfreies Ablösen der darüber aufgebrachten Halbleiter- und Rückelektrodenschicht sichergestellt wird. Durch die gute Benetzung wird zugleich in unkontrolliertes Ausfransen der Ablösemasse verhindert und damit ein optisch fehlerfreies Bild der erfindungsgemäß hergestellten transparenten Teilbereiche erzeugt.

Die mit dem Tintenstrahldrucker aufgebrachte Ablösemasse weist je nach Relativgeschwindigkeit zwischen dem Tintenstrahldrucker und dem mit der Frontelektrodenschicht versehenen Substrat sowie der Größe der vom Tintenstrahldrucker abgegebenen Tropfen gerade oder durch Aneinanderreihung diskreter Tropfen bogenförmig gewölbte Ränder auf.

Der vorzugsweise verwendete kontinuierliche Tintenstrahldrucker kann ein Ein- oder Mehrstrahler sein. Der Strahl tritt dabei durch einen piezoelektrischen Wandler in einzelnen Tropfen aus der Düse aus, die mit Ladeelektroden elektrostatisch aufgeladen und mit Ablenkelektroden seitlich abgelenkt werden können.

Damit können mit dem Tintenstrahldrucker einer oder mehreren nebeneinander liegende Spuren aus der Ablösemasse gebildet werden. Die Spuren können sich überlappen oder im Abstand angeordnet sein. Damit kann die Ablösemasse mit einer Fahrbewegung bei einer Spur mit einer Breite von beispielsweise 100 bis 300 µm und bei zwei einander berührenden Spuren mit einer Breite von z. B. 200 bis 600 µm aufgetragen und damit ein linienförmiger transparenter Teilbereich entsprechender Breite erzeugt werden, wobei bei zwei im Abstand angeordneten Spuren der Ablösemasse linienförmige transparente Teilbereiche mit noch größerer Breite erhalten werden können.

Die Benetzung der Frontelektrode mit Ablösemasse im Falle sich kreuzender Linien ist besonderes Charakteristikum Bei sich kreuzenden Tinten-Linien kann sich die zweite Linie im Bereich des Kreuzungspunktes einschnüren. Dieses Einschnüren kann bis ca. 50% der Linienbreite betragen. Hier ist die Reihenfolge, nämlich zuerst die Ablösemasse für die Trenngräben der Serienverschaltung und dann die Ablösemasse für die Trenngräben parallel zum Stromfluss auf die Frontelektrode aufzutragen, einzuhalten. Diese Reihenfolge kann die elektrische Trennung der Rückelektrode definiert und reproduzierbar gewährleisten.

Das heißt, wenn bei einem ein Quadratmeter großem Modul die Breite der aufgetragenen Ablösemasselinie ca. 250 µm beträgt, verringert sich die Bearbeitungszeit zum eingangs genannten Laserverfahren beispielsweise um den Faktor 5 von 2000 Sekunden auf 400 Sekunden bzw. bei einer ca. 500 µm breiten Ablösemasselinie auf 200 Sekunden.

Nachstehend ist die Erfindung anhand der Zeichnung beispielhaft näher erläutert. Darin zeigen jeweils schematisch:
Figur 1 eine Ansicht eines semitransparenten photovoltaischen Moduls von der Rückseite;
Figur 2 einen Schnitt entlang der Linie II-II in Figur 1 in vergrößerter Wiedergabe;
Figur 2a eine der Figur 2 entsprechende Ansicht vor dem Entfernen der Ablösemasse und der darauf abgeschiedenen Halbleiter- und Rückelektrodenschicht;
Figur 3 einen Schnitt entlang der Linie III-III in Figur 1 in vergrößerter Wiedergabe;
Figur 3a eine der Figur 3 entsprechende Ansicht vor dem Entfernen der Ablösemasse und der darauf abgeschiedenen Halbleiter- und Rückelektrodenschicht;
Figur 4 und 5 die Seitenansicht bzw. verkleinerte Draufsicht einer Vorrichtung zum Auftragen der Ablösemasse auf das mit der Frontelektrodenschicht versehene Substrat; und
Figur 6a und 6b jeweils zwei mit dem Tintenstrahldrucker auf die Frontelektrode aufgetragenen Ablösemassespuren.

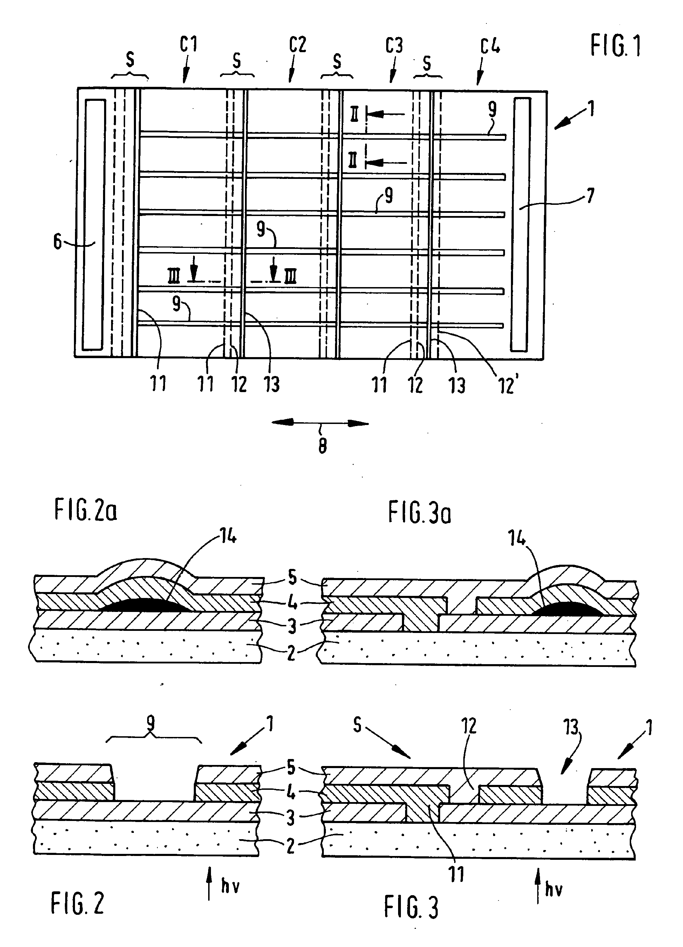

Gemäß Figur 1, 2 und 3 weist ein photovoltaisches Modul 1 ein elektrisch isolierendes transparentes Substrat 2, beispielsweise eine Glasplatte auf, die an der Seite des Moduls 1 angeordnet ist, auf die das mit dem Pfeil hv gekennzeichnete einfallende Licht fällt. Auf der von der Lichteinfallsseite hν abgewandten Seite ist das Substrat 2 mit einer transparenten Frontelektrodenschicht 3 z. B. aus TCO, einer Halbleiterschicht 4 und einer undurchsichtigen metallischen Rückelektrodenschicht 5 beschichtet.

Das Modul 1 besteht aus mehreren Zellen C1 bis C4, die durch eine Serienverschaltung S miteinander verbunden sind. An den beiden Enden des Moduls 1 ist auf der Rückelektrodenschicht 5 eine Kontaktzone 6 bzw. 7 vorgesehen, mit denen der Strom von dem photovoltaischem Modul 1 abgegriffen wird, der in dem Modul 1 von der einen Kontaktzone 6 bzw. 7 zur anderen Kontaktzone 7 bis 6 in Richtung des Pfeils 8 fließt. Die Kontaktzone 6 bildet also den Pluspol des Moduls 1, und die Kontaktzone 7 den Minuspol.

Jede Zelle C1 bis C4 weist mehrere im Abstand angeordneten linienförmige Teilbereiche 9 auf, an denen gemäß Figur 2 die Halbleiterschicht 4 und die undurchsichtige Rückelektrodenschicht 5 entfernt worden sind, wodurch die Teilbereiche 9 durchsichtig sind. Die durchsichtigen linienförmigen Teilbereiche 9 erstrecken sich in Stromflussrichtung 8 und weisen jeweils den gleichen Abstand quer zur Stromflussrichtung 8 auf. Dabei fluchten die transparenten Teilbereiche 9 der einzelnen Zellen C1 bis C4 miteinander.

Das Modul 1 erhält damit eine partielle oder Semitransparenz, die es erlaubt, vergleichbar mit einem Store-Vorhang entgegen dem einfallenden Licht hν durch das Modul 1 zu sehen.

Die Serienverschaltung S zwischen zwei benachbarten Zellen C1 bis C4 weist gemäß Figur 3 eine mit der Halbleiterschicht 4 verfüllte Trennlinie 11 in der Frontelektrode 3, eine mit der Rückelektrodenschicht 5 verfüllte Trennlinie 12 in der Halbleiterschicht 4 und eine durch Entfernen der Halbleiterschicht 4 und der Rückelektrodenschicht 5 gebildete Trennlinie 13 auf, wobei letztere auch in Figur 1 zu sehen ist, während die Trennlinien 11 und 12 in Figur 1 gestrichelt angedeutet sind. Die Trennlinien 13, die senkrecht zu den durchsichtigen Teilbereichen 9 verlaufen, sind gleichfalls durchsichtig, wodurch die partielle Transparenz des Moduls 1 weiter erhöht wird.

Weiter muss bei einem diskreten Minuspol 7 des Moduls 1, der ebenfalls die durchsichtigen Teilbereiche 9 parallel zum Stromfluss, wie auch eine durchsichtige Trennlinie 13 der Serienverschaltung S aufweist, eine weitere Trennlinie 12' in der Halbleiterschicht 4, gespiegelt zur Trennlinie 13 der Rückelektrodenschicht 5 der Serienverschaltung, gebildet werden. Ohne diese zusätzliche Trennlinie 12' in der Halbleiterschicht 4 hätte das Modul 1 keinen Minuspol 7. Eine elektrische Kontaktierung durch die z.B. parallel zur Stromrichtung verlaufenden durchsichtigen Teilbereiche 9, die das elektrische Minus-Potential der zu der Zelle 4 mit diesem Minuspol 7 angrenzenden Zelle 3 hat, ist eine alternative Möglichkeit, dass negative Potential des Moduls 1 abgreifen zu können. Zu diesem Fall ist die technisch zuverlässig Kontaktierung zu beachten.

Es versteht sich, dass auf Kosten der Transparenz alle oder einige der Trennlinien 13 auch weggelassen werden können, wobei dann auch die Trennlinie 12' weggelassen werden kann.

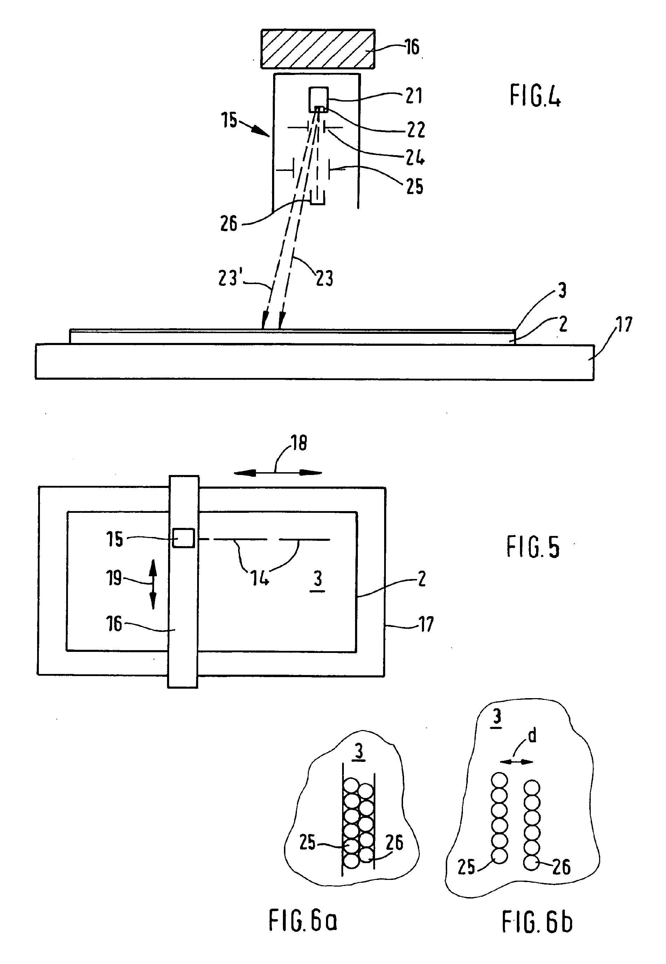

Zur Bildung der durchsichtigen Bereiche 9 und der durchsichtigen Trennlinien 13 wird eine Ablösemasse 14 mit einem Tintenstrahldrucker 15 gemäß Figur 4 und 5 auf das mit der durchsichtigen Frontelektrodenschicht 3 versehene Substrat 2 aufgetragen.

Dazu kann der Tintenstrahldrucker 15 an einem Träger 16 angeordnet sein, der entlang dem Tisch 17 in Richtung des Doppelpfeils 18 verfahrbar ist. Der Tintenstrahldrucker 15 kann zudem entlang dem Träger 16 und damit quer zu dem Tisch 17 in Richtung des Doppelpfeils 19 verfahren werden.

Damit kann durch Verfahren des Trägers 16 entsprechend dem Pfeil 18 nach links bei einer bestimmten Position des Tintenstrahldruckers 15 gegenüber dem Träger 16 mit dem Tintenstrahldrucker die Ablösemasse 14 auf die Frontelektrodenschicht 3 in hintereinander angeordneten fluchtenden Linien gemäß Figur 5 zur Bildung jeweils miteinander fluchtender linienförmiger Teilbereiche 9 auf den Zellen C1 bis C4 gemäß Figur 1 aufgetragen werden.

Demgegenüber wird die Ablösemasse 14 zur Bildung der quer verlaufenden Trennlinien 13 durch Verfahren des Tintenstrahldruckers 15 entlang dem Träger 16 entsprechend dem Pfeil 19 aufgetragen.

Nach dem Auftragen der Ablösemasse 14 wird die Halbleiterschicht 4 beispielsweise durch PECVD und die Rückelektrodenschicht 5 z. B. durch Sputtern aufgetragen, sodass der in Figur 2a bzw. Figur 3a dargestellte Schichtaufbau entsteht, bei dem die Ablösemasse 14 mit der Halbleiterschicht 4 und der Rückelektrodenschicht 5 bedeckt ist. Durch Eintauchen des Moduls 1 beispielsweise in Wasser wird die Ablösemasse 14 und der auf ihr abgeschiedene Bereich der Halbleiterschicht 4 und der Rückelektrodenschicht 5 entfernt, um die durchsichtigen Teilbereiche 9 bzw. durchsichtigen Trennlinien 13 zu bilden.

Gemäß Figur 4 weist der Tintenstrahldrucker 15 einen piezoelektrischen Wandler 21 hinter der Düse 22 auf, der die von einem nicht dargestellten Vorratsbehälter zugeführte Ablösemasse-Suspension als Tropfen 23 mit einer Ladeelektrode 24 elektrostatisch auflädt, die anschließend mit einer Ablenkelektrode 25 seitlich abgelenkt werden können, wie durch den Strahl 23' veranschaulicht.

Damit kann gemäß Figur 6a bzw. 6b die Ablösemasse in zwei einander überlappenden Spuren 25, 26 bzw. in zwei mit einem Abstand d angeordneten Spuren 25, 26 auf die Frontelektrodenschicht 3 aufgetragen werden. Der Tintenstrahldrucker 15 ist als kontinuierlicher Drucker ausgebildet, d. h. die Tropfen 23 werden auch in den Pausen, beispielsweise für das Be- und Entladen der Substrate gebildet. Dazu können die Tropfen 23 mit der Ablenkelektrode 25 einem Auffangbehälter 26 am Druckkopf des Tintenstrahldruckers 15 zugeführt werden, von wo sie im Kreislauf dem nicht dargestellten Vorratsbehälter zugeführt werden.

## Patentansprüche

1. Verfahren zur Herstellung eines semitransparenten photovoltaischen Moduls (1), bei dem ein transparentes Substrat (2) mit einer transparenten Frontelektrodenschicht (3), einer Halbleiterschicht (4) und einer metallischen Rückelektrodenschicht (5) beschichtet wird, worauf Teilbereiche (9) der Halbleiterschicht (4) und der Rückelektrodenschicht (5) entfernt werden, um durchsichtige Teilbereiche (9) zu bilden, **dadurch gekennzeichnet, dass** nach dem Beschichten des Substrats (2) mit der Frontelektrodenschicht (3) auf die Frontelektrodenschicht (3) an den Bereichen, an denen die Halbleiterschicht (4) und die Rückelektrodenschicht (5) entfernt werden sollen, mit einem Tintenstrahldrucker (15) eine Ablösemasse (14) aufgetragen wird, worauf die Halbleiterschicht (4) und die Rückelektrodenschicht (5) auf der mit der Ablösemasse (14) versehenen Frontelektrodenschicht (3) abgeschieden werden und anschließend im Bereich der Ablösemasse (14) die Halbleiterschicht (4) und die Rückelektrodenschicht (5) zusammen mit der Ablösemasse (14) von der Frontelektrodenschicht (3) entfernt wird, um die durchsichtigen Teilbereiche (9) zu bilden.

2. Verfahren zur Herstellung eines photovoltaischen Moduls nach Anspruch 1, das aus Zellen (C1 bis C4) besteht, die durch Kontakt der Rückelektrodenschicht (5) einer Zelle (C1 bis C4) mit der Frontelektrodenschicht (3) der benachbarten Zelle (C1 bis C4) serienverschaltet sind, wobei zur Serienverschaltung (S) eine quer zur Stromflussrichtung (8) verlaufende Trennlinie (13) vorgesehen ist, an der die Halbleiterschicht (4) und die Rückelektrodenschicht (5) entfernt ist, wodurch ein durchsichtiger Teilbereich gebildet wird, **dadurch gekennzeichnet, dass** nach dem Beschichten des Substrats (2) mit der Frontelektrodenschicht (3) auf die Frontelektrodenschicht (3) mit dem Tintenstrahldrucker (15) die Ablösemasse (14) an den Bereichen aufgetragen wird, an denen die Trennlinie (13) in der Halbleiterschicht (4) und der Rückelektrodenschicht (5) gebildet werden soll.

3. Verfahren nach Anspruch 1 oder 2, **dadurch gekennzeichnet, dass** zur Bildung der Ablösemasse (14) mit dem Tintenstrahldrucker eine Dispersion oder Lösung der Ablösemasse in einem Lösungsmittel aufgetragen wird, die anschließend getrocknet wird.

4. Verfahren nach Anspruch 1 oder 2, **dadurch gekennzeichnet, dass** zum Entfernen der Halbleiterschicht (4) und der Rückelektrodenschicht (5) zusammen mit der Ablösemasse (13) von der Frontelektrodenschicht (3) das Modul (1) einem Lösungsmittel ausgesetzt wird.

5. Verfahren nach Anspruch 3, **dadurch gekennzeichnet, dass** die Ablösemasse (14) nach dem Trocknen einen Schichtdicke aufweist, die in der Größenordnung der Schichtdicke der Halbleiterschicht (4) ist.

6. Verfahren nach Anspruch 1, **dadurch gekennzeichnet, dass** die Teilbereiche (9), an denen die Halbleiterschicht (4) und die Rückelektrodenschicht (5) entfernt werden, linienförmige Bereiche sind.

7. Verfahren nach Anspruch 2 und 6, **dadurch gekennzeichnet, dass** die linienförmigen Bereiche (9) senkrecht zu der Trennlinie (13) in der Halbleiterschicht und der Rückelektrodenschicht (5) der Serienverschaltung (S) gebildet werden.

8. Verfahren nach Anspruch 7, **dadurch gekennzeichnet, dass** zuerst die Ablösemasse (14) für die Trennlinien (13) der Serienverschaltung (S) und dann die Ablösemasse (14) für die durchsichtigen Bereiche (9) aufgetragen wird.

9. Verfahren nach Anspruch 2 oder 6, **dadurch gekennzeichnet, dass** mit dem Tintenstrahldrucker (15) nebeneinander liegende Spuren (25, 26) der Ablösemasse (14) aufgetragen werden.

10. Verfahren nach einem der vorstehenden Ansprüche, **dadurch gekennzeichnet, dass** bei einem diskreten elektrischen Minuspol (7) mit durchsichtigen Teilbereichen (9) parallel zum Stromfluss und durchsichtigen Trennlinien (13) der Serienverschaltung (S) eine zweite Trennlinie (12') in der Halbleiterschicht (4) parallel und spiegelbildlich zur Trennlinie (13) der Rückelektrodenschicht (5) der Serienverschaltung (S) gebildet wird.

11. Vorrichtung zur Herstellung eines photovoltaischen Moduls nach einem der vorstehenden Ansprüche, **dadurch gekennzeichnet, dass** der Tintenstrahldrucker (15) und das mit der Frontelektrodenschicht (3) beschichtete Substrat (2) relativ zueinander bewegbar angeordnet sind.

12. Vorrichtung nach Anspruch 11, **dadurch gekennzeichnet, dass** der Tintenstrahldrucker (15) an einem Träger (16) befestigt ist, der zumindest in eine Richtung (18) bewegbar ist.

13. Vorrichtung nach Anspruch 11 oder 12, **dadurch gekennzeichnet, dass** ein zumindest in einer Richtung bewegbarer Schlitten zur Aufnahme des mit der Frontelektrode (3) beschichteten Substrats vorgesehen ist.

14. Vorrichtung nach Anspruch 11, **dadurch gekennzeichnet, dass** der Tintenstrahldrucker (15) ein kontinuierlicher Tintenstrahldrucker ist, der die nicht benötigte Ablösemasse-Dispersion oder -Lösung am Druckkopf auffängt und dem Vorratsbehälter wieder zuführt.

15. Vorrichtung nach Anspruch 11, **dadurch gekennzeichnet, dass** der Tintenstrahldrucker (15) Ladeelektroden (24) zum elektrostatischen Aufladen und Ablenkelektroden (25) zur seitlichen Ablenkung der aus der Düse (22) austretenden Tropfen (23) der Ablösemasse-Dispersion bzw. -Lösung aufweist.
